# EUROPEAN PATENT APPLICATION

(11) **EP 2 803 989 A1**
(43) Date of publication of application: **19.11.2014**
(21) Application number: 14167731.0
(22) Date of filing: 09.05.2014
(51) Int. Cl.: G01N 27/406, G01N 27/417

(54) **Electrode testing method and electrode testing apparatus**

(30) Priority: 13.05.2013 JP 2013101322
(71) Applicant: NGK Insulators, Ltd., Nagoya-city, Aichi 467-8530 (JP)
(72) Inventor: Kato, Kenji, Nagoya-city Aichi 467-8530 (JP); Ina, Noriyuki, Nagoya-city Aichi 467-8530 (JP)
(74) Representative: Naylor, Matthew John

(57) **Abstract**

In a state in which two probes contact each electrode, the contact of the probes with each electrode is checked at the electrode (S100), and a short-circuit test between electrodes is conducted using each one probe from each of pairs of probes where contact has been confirmed (S110, S140). In this manner, since a short-circuit test between electrodes is conducted after it is confirmed that the probes contact each electrode, a short-circuit determination error caused by the fact that the probes are not in contact with each electrode is prevented, thereby improving the reliability of a test.

## Description

This application claims the benefit of priority from Japanese Patent Application No. 2013-101322 filed on May 13, 2013.

### TECHNICAL FIELD

The present invention relates to an electrode testing method and an electrode testing apparatus.

### BACKGROUND ART

Hitherto, testing the presence of, for example, a short circuit between electrodes using probes that contact the electrodes is known. For example, in PTL 1, in testing a planar electrode including a planar first electrode and a planar second electrode arranged across a rectangular electrolytic film, a planar terminal contacting the entirety of a face of the first electrode, and a plurality of probes arranged in a lattice on a face of the second electrode are prepared. In a state in which the terminal and the probes sandwich the planar electrode, a predetermined voltage is applied across the terminal and the probes. Among portions of the planar electrode, at a portion (lattice point) where a short circuit is occurring, a resistance value is small, and a great current flows, compared with portions where a short circuit is not occurring. On the basis of this, each portion is tested for the presence of a short circuit.

In addition, such a test for the presence of a short circuit is performed also in a gas sensor that detects the concentration of a predetermined gas (NOx or the like)
in a gas to be measured, such as exhaust gas of a vehicle or the like. For example, in PTL 2, three element terminals formed on a gas sensor element are respectively connected to control terminals of a gas sensor control circuit via wiring, and the control terminals are tested for the presence of a short circuit.

### CITATION LIST

### PATENT LITERATURE

[PTL 1] Japanese Unexamined Patent Application Publication No. 2012-27004
[PTL 2] Japanese Unexamined Patent Application Publication No. 2006-275911

### DISCLOSURE OF INVENTION

In the above-described test using the probes, a resistance value increases even when the probes and the electrodes are not certainly in contact with each other due to the winding of the probes, positional displacement, or the like. This state is similar to the case in which no short circuit is occurring. Therefore, even if a short circuit is actually occurring, a determination error determining that no short circuit is occurring may occur.

It is a main object of an electrode testing method and an electrode testing apparatus of the present invention to perform an efficient test while improving the reliability of the test.

To achieve the above-described main object, an electrode testing method and an electrode testing apparatus of the present invention adopt the following means.

According to the present invention, an electrode testing method that tests electrical characteristics between two electrodes includes:
a determination step of determining, at each of the electrodes, in a state in which at least two probes contact each of the electrodes, electrical conduction between the at least two probes contacting the same electrode; and
a testing step of testing electrical characteristics between the electrodes using at least one probe at each of the electrodes, among probes determined to be electrically conducting in the determination step.

In an electrode testing method of the present invention, in a state in which at least two probes contact each electrode, electrical conduction between the at least two probes contacting the same electrode is determined at each electrode; and electrical characteristics between electrodes are tested using at least one probe at each of the electrodes, among probes determined to be electrically conducting. Accordingly, because the electrical characteristics between electrodes can be tested after it is confirmed in advance that the probes certainly contact each electrode, a determination error caused by a contact failure between the probes and each electrode can be prevented, thereby improving the reliability of a test. In addition, since it becomes unnecessary to conduct a test again due to a determination error, even if the contact between each electrode and the probes is checked, a test can be efficiently conducted. Therefore, an efficient test can be conducted while improving the reliability thereof.

In addition, in the electrode testing method of the present invention, in the determination step, in a state in which the two probes contact each of the electrodes, electrical conduction between the two probes contacting the same electrode may be determined at each of the electrodes; and, in the testing step, electrical characteristics between the electrodes may be tested using each one probe at each of the electrodes, among probes determined to be electrically conducting in the determination step. In doing so, even in the case where electrical conduction of the probes is checked in advance, the number of probes to be prepared can be limited to a minimum, and a test can be efficiently conducted.

In addition, in the electrode testing method of the present invention, the electrodes may include a combination of two electrodes, among three or more electrodes. The greater the number of electrodes, the longer the time it takes to conduct a test again due to a determination error caused by a contact failure, and the greater a test loss. It is thus significant to apply the present invention.

In addition, in the electrode testing method of the present invention, in the determination step, in a state in which the at least two probes contact each of the electrodes, electrical conduction between the at least two probes contacting the same electrode may be determined at each of the electrodes; and the testing step may be performed after it is determined in the determination step that at least one probe is electrically conducting at each of the electrodes. In doing so, because the electrical characteristics between electrodes can be tested at one time after it is confirmed that the probes certainly contact the respective electrodes, a test can be conducted more efficiently, compared with the case in which an electrical conduction determination between probes contacting each electrode and a test of electrical characteristics are alternately repeated.

In addition, in the electrode testing method of the present invention, each of the electrodes may be provided at a gas sensor that detects a gas concentration of a gas to be measured. Since the number of electrodes tends to be relatively great in such a gas sensor, it is significant to apply the present invention.

According to the present invention, an electrode testing apparatus that tests electrical characteristics between two electrodes includes:
at least two probes provided for each of the electrodes;
determination device that determines, at each of the electrodes, in a state in which the probes contact each of the electrodes, electrical conduction between the at least two probes contacting the same electrode; and
testing device that tests electrical characteristics between the electrodes using at least one probe at each of the electrodes, among probes determined by the determination device to be electrically conducting.

In an electrode testing apparatus of the present invention, in a state in which at least two probes that are provided for each of electrodes contact each of the electrodes, electrical conduction between the at least two probes contacting the same electrode is determined at each of the electrodes; and electrical characteristics between the electrodes are tested using at least one probe at each of the electrodes, among probes determined to be electrically conducting. Accordingly, because the electrical characteristics between electrodes can be tested after it is confirmed in advance that the probes certainly contact each electrode, a determination error caused by a contact failure between the probes and each electrode can be prevented, thereby improving the reliability of a test. In addition, since it becomes unnecessary to conduct a test again due to a determination error, even if the contact between each electrode and the probes is checked, a test can be efficiently conducted. Furthermore, because at least two probes are provided for each electrode, the assured contact between each electrode and the probes can be easily confirmed. Therefore, an efficient test can be conducted while improving the reliability thereof.

### BRIEF DESCRIPTION OF DRAWINGS

Fig. 1 is a diagram illustrating the schematic configuration of an electrode testing apparatus 10;
Fig. 2 is a diagram illustrating the schematic configuration of a gas sensor 100 including electrodes to be tested;
Fig. 3 is an explanatory diagram illustrating the positional relationship between element electrodes 116 on a face of a sensor element 114 and contact fittings 126;
Fig. 4 includes explanatory diagrams illustrating how a relay matrix 16 connects, in terms of a circuit, each probe 12 and a resistance value detector 18;
Fig. 5 is a flowchart illustrating an example of an electrode testing process routine;
Fig. 6 is an explanatory diagram illustrating how the probes 12 of the electrode testing apparatus 10 and terminal electrodes 134B contact each other; and
Fig. 7 is an explanatory diagram illustrating how the probes 12 contact the element electrodes 116 of the sensor element 114.

### BEST MODE FOR CARRYING OUT THE INVENTION

Next, an embodiment of the present invention will be described using the drawings.

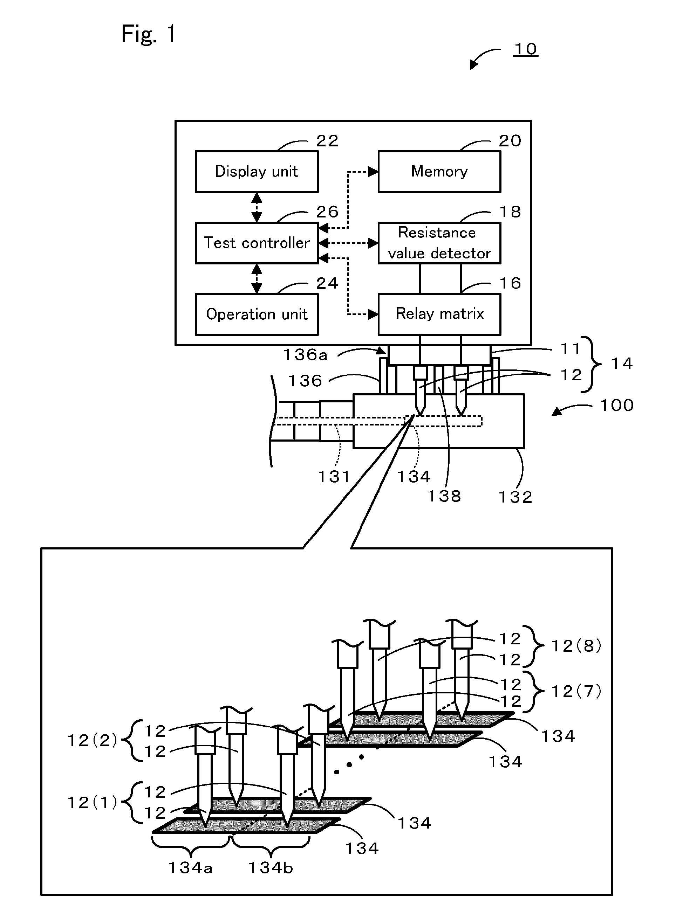

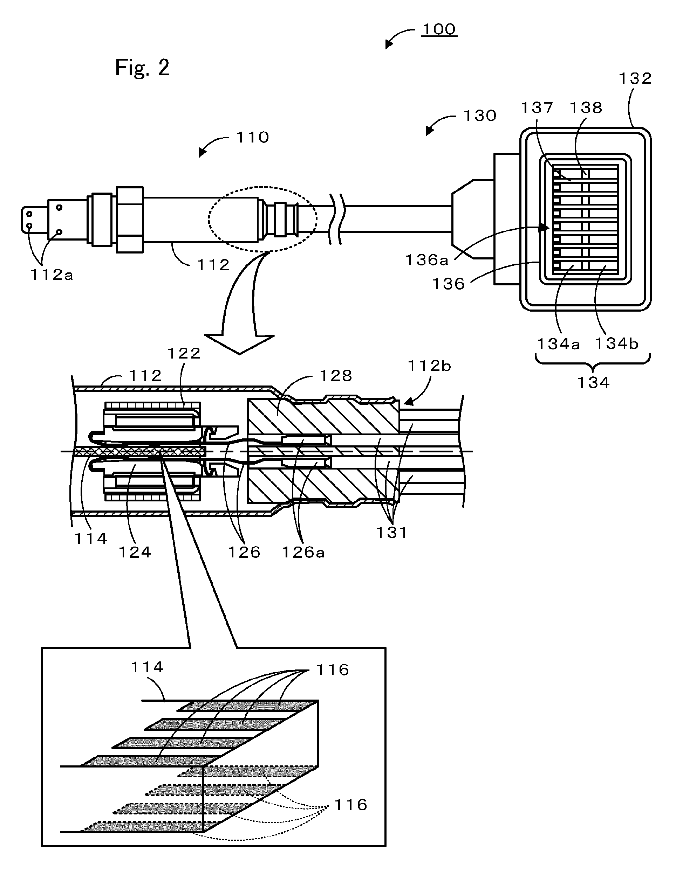

Fig. 1 is a diagram illustrating the schematic configuration of an electrode testing apparatus 10. Fig. 2 is a diagram illustrating the schematic configuration of a gas sensor 100 including electrodes to be tested. Firstly, the gas sensor 100 will be described. The gas sensor 100 includes a sensor main body 110 that is attached to, for example, an exhaust gas tube of a vehicle and that measures the concentration of a predetermined gas component (NOx, O₂, or the like) included in exhaust gas, and a cable 130 that binds a plurality of lead lines 131 extended from the sensor main body 110 to the outside and that is connected to a control unit of the vehicle or the like.

The sensor main body 110 includes, in a metal tube-shaped cover 112 in which a plurality of exhaust gas intruding holes 112a are formed on the tip side, a sensor element 114 that is formed in a thin and long plate shape and that measures the concentration of a predetermined gas component, a ceramic housing 124 that is attached so as to sandwich the front face and the back face of the sensor element 114 by swaging of a metal ring 122, contact fittings 126 that are held against the housing 124 and that contact the sensor element 114 (element electrodes 116 described later), and a rubber stopper 128 that seals a rear-end opening 112b of the cover 112 from which the lead lines 131 are extended.

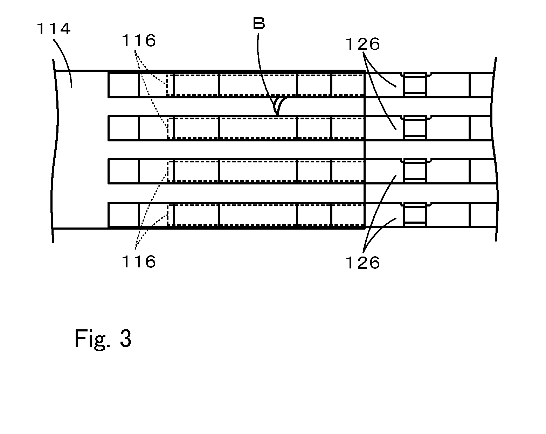

The sensor element 114 is formed by stacking a plurality of ceramics substrates formed of zirconia (ZrO₂) or the like, and the plurality of element electrodes 116 are formed on the front face and the back face of the rear end (an end portion positioned on the opening 112b-side of the cover 112). These element electrodes 116 apply a voltage to the sensor element 114 and extract an electromotive force or current that is generated in accordance with the gas concentration detected by the sensor element 114. In this embodiment, the number of the sensor electrodes 116 is eight in total, four on each of the front and back sides of the sensor element 114, and the element electrodes 116 are electrically connected to not-illustrated electrodes embedded in the tip of the sensor element 114 (in an end portion positioned on the tip side of the cover 112) via an electric circuit in the sensor element 114. Fig. 3 illustrates the positional relationship between the element electrodes 116 on a face of the sensor element 114 and the contact fittings 126, excluding the ring 122 and the housing 124.

The contact fittings 126 are provided in a plurality (eight in this embodiment) so as to respectively contact the plurality of element electrodes 116 on the sensor element 114. The contact fittings 126 are respectively extended to the outside of the housing 124 and are electrically connected to the lead lines 131 at contact portions 126a that are crimp contacts. Therefore, the number of the contact portions 126a and the number of the lead lines 131 are the same as the number of the element electrodes 116. Note that the contact fittings 126 are manufactured by blanking a metal plate in a predetermined size and applying a widing process that winds contact portions with the element electrodes 116, the contact portions 126a, and the like to a predetermined shape. Therefore, at the time of a blanking process, burrs B such as those illustrated in Fig. 3 may occur. Depending on the size of the burrs B, adjacent contact fittings 126 may be short circuited.

Regarding the rubber stopper 128, the contact portions 126a (contact fittings 126) are arranged in a penetrating hole that penetrates through the interior of the rubber stopper 128, and the lead lines 131 are inserted through the penetrating hole. Since the rubber stopper 128 seals the opening 112b by being swaged in a radial direction along with the metal cover 112, if swaging is insufficient, the degree of sealing becomes smaller, which may result in causing an adverse effect on the detection accuracy of the sensor element 114. Therefore, the cover 112 and the rubber stopper 128 are sufficiently swaged in the step of manufacturing the gas sensor 100. Although the rubber stopper 128 has a characteristic that may endure such swaging, the rubber stopper 128 may crack as a result of swaging, depending on manufacturing variations (variations in the dimensions and hardness of the rubber stopper 128). In such a case, the contact portions 126a (contact fittings 126), which are arranged in the penetrating hole of the rubber stopper 128, may contact one another and may be shorted.

The cable 130 is connected to a control unit of a vehicle, for example, via a convex (convex in the near side of the sheet in Fig. 2) connector 132 attached to an end portion. On the connector 132, a plurality of (eight in this embodiment) planar terminal electrodes 134 are provided, which are connected to the plurality of lead lines 131 via not-illustrated crimp contacts, and the terminal electrodes 134 are exposed from an opening 136a formed on a convex portion 136. In the opening 136a, first dividers 137 that divide the adjacent terminal electrodes 134, and second dividers 138 that are orthogonal to the first dividers 137 at substantially the center of the first dividers 137 are formed. With the second dividers 138, areas where the terminal electrodes 134 are accessible from the outside are divided into first areas 134a and second areas 134b.

The electrode testing apparatus 10 illustrated in Fig. 1 conducts a test between the terminal electrodes 134 provided on the above-described gas sensor 100 (connector 132). The electrode testing apparatus 10 includes a probe unit 14 including a plurality of probes 12 that protrude downward in Fig. 1 from a substantially rectangular parallelepiped unit base 11, a relay matrix 16 that can switch connections of the plurality of probes 12, a resistance value detector 18 that detects the resistance value between two probes 12 that are caused by the relay matrix 16 to be in a contact state, a memory 20 that stores various types of data necessary for a test, a display unit 22 that displays a test result or the like, an operation unit 24 where a power button of the electrode testing apparatus 10, a start button that gives an instruction to start a test, and the like are provided, and a test controller 26 that controls the overall electrode testing apparatus 10.

The probe unit 14 is configured as a unit including a plurality of pairs of probes 12 that are capable of contacting the respective terminal electrodes 134 of the gas sensor 100. Since the eight terminal electrodes 134 are provided in this embodiment, the probe unit 14 includes eight pairs of probes 12 (probes 12(1), 12(2), ..., 12(7), and 12(8)). The probes 12 are probe pins whose tips are tapered. By pressing the probes 12 downward in Fig. 1 by a not-illustrated spring, the probes 12 are capable of extending in the vertical direction. In addition, the unit base 11 is formed to fit into the opening 136a of the connector 132. By contacting the inner wall of the edge of the opening 136a or the like (may be a first divider 137 or a second divider 138), the unit base 11 is fitted into a predetermined position of the opening 136a. When the unit base 11 is fitted into the opening 136a of the connector 132, the pairs of probes 12 are configured in such a manner that one of each pair of probes 12 contacts the first area 134a of a corresponding one of the terminal electrodes 134 and the other probe 12 contacts the second area 134b of the terminal electrode 134. At this time, with a pressing force of the spring, the probes 12 contact the areas of the terminal electrodes 134 while being pressed against these areas.

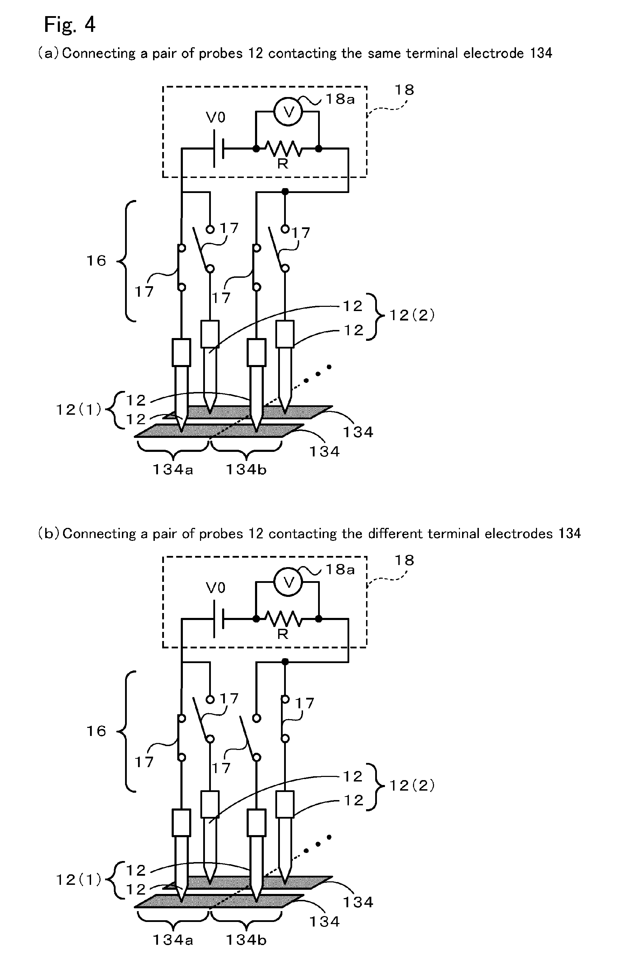

The relay matrix 16 is configured to be capable of switching between connection and disconnection of each probe 12 and the resistance value detector 18. Here, Fig. 4 includes explanatory diagrams illustrating how the relay matrix 16 connects, in terms of a circuit, each probe 12 and the resistance value detector 18. Note that, in Fig. 4, only some of the eight pairs of probes 12 (probes 12(1) and (2)) are illustrated. As illustrated in Fig. 4, the relay matrix 16 includes a plurality of change-over switches 17 that are capable of switching between connection and disconnection of a corresponding one of the probes 12, and switches these change-over switches 17 in response to switch changing signals from the test controller 26. Note that the change-over switches 17 may be switched on the basis of a manual operation performed by a tester.

As illustrated in Fig. 4(a), the relay matrix 16 connects, in terms of a circuit, a pair of probes 12 contacting the same terminal electrode 134 (here, the probes 12(1)) to the resistance value detector 18 by turning on the change-over switches 17 of the pair of probes 12 contacting the same terminal electrode 134 and turning off the other change-over switches 17. Note that the relay matrix 16 is configured to be capable of similarly connecting not only the probes 12(1), but also the probes 12(2) to (8) to the resistance value detector 18. In addition, as illustrated in Fig. 4(b), out of two pairs of probes 12 contacting different terminal electrodes 134 (here, the probes 12(1) and (2)), by turning on the change-over switch 17 of one of each of the two pairs of probes 12 and by turning off the other change-over switches 17, two probes 12, including one of each of the two pairs of probes 12 contacting different terminal electrodes 134, are connected, in terms of a circuit, to the resistance value detector 18. Note that, in Fig. 4(b), for convenience of the illustration, the probe 12 contacting the first area 134a, which is out of the probes 12(1), and the probe 12 contacting the second area 134b, which is out of the probes 12(2), are connected to the resistance value detector 18. However, the case is not limited to this configuration. For example, out of the probes 12(1) and (2), the probes 12 contacting the first areas 134a may be connected to the resistance value detector 18, or the probes 12 contacting the second areas 134b may be connected to the resistance value detector 18. In addition, the relay matrix 16 is configured to be capable of similarly connecting not only the combinations of the probes 12(1) and (2), but also all the combinations of the probes 12(1) to (8) to the resistance value detector 18. In this manner, the relay matrix 16 connects, in terms of a circuit, out of the eight pairs of probes 12, two probes 12 of the same pair or two probes 12 of different pairs to the resistance value detector 18.

As illustrated in Fig. 4, the resistance value detector 18 includes a voltage source V0 for applying a predetermined reference voltage (such as 1.5 V), a reference resistor R with a predetermined resistance value (such as 200 kΩ), and a voltage measuring unit 18a that measures a voltage generated at the reference resistor R. Two probes 12 are connected to the voltage source V0, the reference resistor R, and the voltage measuring unit 18a via the relay matrix 16. The resistance value detector 18 applies a reference voltage from the voltage source V0 on the basis of a voltage application signal sent from the test controller 26 in a state in which the two probes 12 are connected. The resistance value detector 18 detects a voltage that is generated at the reference resistor R at the time the reference voltage is applied, detects a resistance value between the two probes 12 on the basis of the measured voltage, the reference voltage, and the resistance value of the reference resistor R, and outputs the detected resistance value to the test controller 26.

The memory 20 includes a ROM storing various programs defining, for example, the order of connections of the probes 12 in a test process described later (the order of switching the change-over switches 17 of the relay matrix 16), various thresholds used in quality determination in a test process, and the like, and a RAM temporarily storing a test result and the like.

The test controller 26 outputs switch changing signals to the relay matrix 16, outputs a voltage application signal to the resistance value detector 18, and a display control signal to the display unit 22. In addition, the test controller 26 receives, as inputs, a detected value (resistance value) from the resistance value detector 18 and an operation signal in accordance with a button of the operation unit 24 operated by the tester.

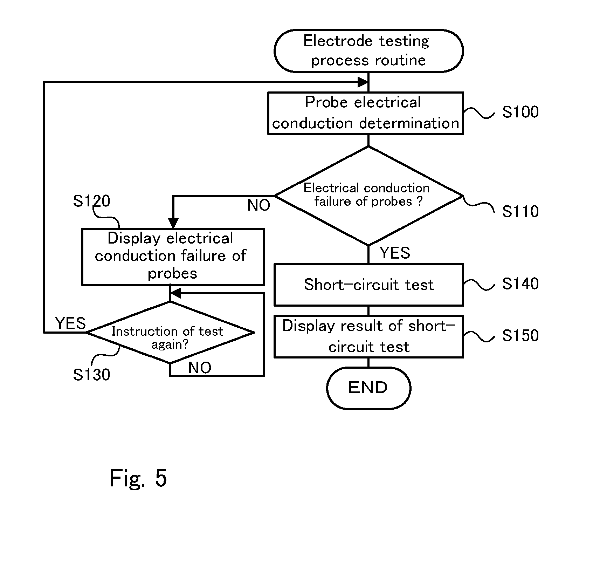

Next, testing electrical characteristics between electrodes, conducted by the electrode testing apparatus 10 configured as above, will be described. Fig. 5 is a flowchart illustrating an example of an electrode testing process routine. Note that testing a short circuit between electrodes is illustrated here as an example of a test of the electrical characteristics. The electrode testing process routine is executed when a start button that gives an instruction to start a test is pressed in a state in which the probe unit 14 (unit base 11) is inserted into the connector 132 (opening 136a) of the gas sensor 100.

In this electrode testing process routine, first the test controller 26 performs a probe electrical conduction determination that determines whether the probes 12 are electrically conducting (step S100). In this electrical conduction determination, switch changing signals are output to the relay matrix 16, thereby sequentially connecting the pairs of probes 12(1), (2), ..., and (8) to the resistance value detector 18 (see Fig. 4(a)). In addition, a resistance value detected by the resistance value detector 18 at a time at which a voltage application signal is input to the resistance value detector 18 to apply a predetermined reference voltage is input, and the input resistance value is compared with a predetermined threshold (such as 10 Ω). Here, in a state in which the probe unit 14 is inserted into the connector 132, normally the pairs of probes 12 contact the respective terminal electrodes 134 and are electrically conducting. Thus, a resistance value detected by the resistance value detector 18 becomes a small value less than or equal to the predetermined threshold. Therefore, if the input resistance value is less than or equal to the predetermined threshold, it is determined that no electrical conduction failure (contact failure of the probes 12 with the terminal electrodes 134) is occurring. In contrast, if some error occurs in the probes 12 and the probes 12 are not in contact with the terminal electrodes 134, a resistance value detected by the resistance value detector 18 becomes a high value exceeding the predetermined threshold. Such a determination is performed in the order of the pairs of probes 12(1), (2), ..., and (8), and whether an electrical conduction failure (contact failure) of the probes 12 is occurring is determined (step S110). Errors of the probes 12 include unsmooth extension of the probes 12 due to, for example, deterioration of the spring which presses the probes 12 (extension failure) and the occurrence of a great deformation (winding) of the probes 12.

In the case where it has been determined in step S110 that an electrical conduction failure of the probes 12 is occurring, the fact that an electrical conduction failure of the probes 12 is occurring (an electrical conduction failure portion) is displayed on the display unit 22 (step S120), and the process waits for an instruction to conduct a test again (step S130). The tester who sees this display checks probes 12 corresponding to the electrical conduction failure portion for an extension failure, the presence of deformation, and the like, and, if no error is found, the tester determines that this has been an accidental electrical conduction failure, reconnects the probe unit 14 to the connector 132, and presses the start button to give an instruction to conduct a test again. In the case where an instruction to conduct a test again is given in step S130, the process returns to step S100 and performs an electrical conduction determination. As described above in this embodiment, even in an electrical conduction determination for the second time, as with the case of an electrical conduction determination for the first time, not only probes 12 at an electrical conduction failure portion, but also all the probes 12 are checked again for electrical conduction (contact with the terminal electrodes 134). This is because an accidental contact failure may occur in the probes 12. When probes 12 where no contact failure has occurred in the beginning are set again, a contact failure may occur in these probes 12. Checking all the probes 12 again is to prevent such overlooking of failures. If an electrical conduction failure continuously occurs in probes 12 even in an electrical conduction determination for the second time or if an explicit error is found in an extension operation or deformation of probes 12, the tester determines that it is difficult to conduct a test with the electrode testing apparatus 10, and cancels the process.

In the case where it has been determined in step S110 that no electrical conduction failures are occurring in the probes 12, next, a short-circuit test is conducted (step S140), the result of the short-circuit test is displayed (whether a short circuit has occurred and a portion between terminal electrodes 134 where a short circuit has occurred) (step S150), and the electrode testing process routine ends. In this short-circuit test, combinations of two terminal electrodes 134 among the eight terminal electrodes 134 are individually tested. As has been described above, a short circuit may occur between adjacent terminal electrodes 134 in the case where burrs B are occurring in the contact fittings 126. In addition, a short circuit may occur between contact portions 126a (contact fittings 126) in the rubber stopper 128, or a short circuit may occur in the sensor element 114. Therefore, a short-circuit test is conducted not only on adjacent terminal electrodes 134, but also on all combinations of the eight terminal electrodes 134 (a total of 28 combinations). In this short-circuit test, switch changing signals are output to the relay matrix 16, and combinations of two probes 12, each one probe 12 from each of the pairs of probes 12(1), (2), ..., and (8), are sequentially connected to the resistance value detector 18 (see Fig. 4(b)). In addition, a voltage application signal is output to the resistance value detector 18 to apply a predetermined reference voltage, and, at this time, the resistance value detector 18 detects a resistance value. This resistance value is input, and this input resistance value is compared with a predetermined threshold (such as 10 Ω). A resistance value detected by the resistance value detector 18 becomes a high value exceeding the predetermined threshold in the case where no short circuit is occurring, and becomes a low value less than or equal to the predetermined threshold in the case where a short circuit is occurring. Such a determination is sequentially performed on combinations of two electrode terminals 134 among the eight terminal electrodes 134 (combinations of two probes 12, each one probe 12 from each of the pairs of probes 12(1), (2), ..., and (8)).

In this short-circuit test, in the case where probes 12 where an electrical conduction failure (contact failure with a corresponding one of the terminal electrodes 134) is occurring are used, the detected resistance value becomes a high resistance value exceeding the predetermined threshold, regardless of the presence of a short circuit. Thus, the detected resistance value does not become a low resistance value even in the case where a short circuit is occurring, and a short-circuit determination error occurs. In this embodiment, because an electrical conduction determination is performed prior to a short-circuit test and it is confirmed in advance that the probes 12 are certainly connected to the terminal electrodes 134, such a determination error can be prevented. Therefore, because the presence of a short circuit can be detected without a determination error (overlooking of a short circuit is prevented), the reliability of the test can be improved. In the electrode testing process routine, a short-circuit test is conducted after an electrical conduction determination is performed because of this reason. Also in this embodiment, the process proceeds to a short-circuit test after completion of an electrical conduction determination of all the probes 12. Here, it may be possible to conceive the case in which an electrical conduction determination of necessary probes 12 (probes 12 contacting terminal electrodes 134 serving as a target of a short-circuit test) is performed during a short-circuit test. For example, an electrical conduction determination of the probes 12(1) and (2) is performed and a short-circuit test between the probes 12(1) and (2) is conducted. Next, an electrical conduction determination of the probes 12(3) is performed, and a short-circuit test between the probes 12(1) and (3) and a short-circuit test between the probes 12(2) and (3) are conducted. Thereafter, an electrical conduction determination and a short-circuit test are similarly repeated. However, in such a case in which an electrical conduction determination of the probes 12 is performed during a short-circuit test, every time probes 12 where an electrical conduction failure is occurring are detected during a short-circuit test, it becomes necessary to reconnect the probe unit 14 to the connector 132 or to reconnect the probe unit 14 and to repeatedly perform an electrical conduction determination of the probes 12. This may increase the number of times (period of time) the short-circuit test is interrupted, thereby increasing a loss. Therefore, as in this embodiment, when the process proceeds to a short-circuit test after completion of an electrical conduction determination of all the probes 12 (an electrical conduction determination and a short-circuit test are each performed at one time), a more efficient test can be conducted.

In addition, after such an electrode test ends, the performance test of the gas sensor 100 or the like is conducted. For example, the test is as follows. The gas sensor 100 is attached to a gas tube similar to a vehicle exhaust gas tube, a gas having a predetermined temperature and a predetermined concentration is caused to flow through the gas tube, a necessary voltage is applied to the element electrodes 116 of the sensor element 114 via the terminal electrodes 134 of the connector 132, outputs from the element electrodes 116 are extracted, and the operation state of the gas sensor 100 is checked. At this time, if a short circuit is overlooked due to a determination error in a short-circuit test, an error value is detected. Thus, it becomes necessary to conduct a test again from a short-circuit test. Not only this, an excessive voltage is applied to the element electrodes 116, and this may break the sensor element 114. In contrast, in this embodiment, the presence of a short circuit is detected without a determination error since a short-circuit test is conducted after the electrical conduction of the probes 12 is confirmed, it is unnecessary to conduct a short-circuit test again, and re-conducting of a short-circuit test due to a determination error can be prevented. In addition, since overlooking of a short circuit can be prevented, the occurrence of a secondary damage such as breakage of the sensor element 114 can be prevented in another test after the electrode test is completed.

Here, the corresponding relationship between main elements of this embodiment and main elements of an electrode testing method of the present invention is clarified. The probes 12 in this embodiment correspond to "probes" in the present invention. Processing in step S100 of the electrode testing process routine in Fig. 5 corresponds to a "determination step", and processing in step S140 of the electrode testing process routine corresponds to a "testing step". In addition, the terminal electrodes 134 correspond to "electrodes", and the gas sensor 100 corresponds to a "gas sensor". Note that the same applies to main elements of an electrode testing apparatus of the present invention. The test controller 26 which executes processing in step S100 of the electrode testing process routine in Fig. 5 corresponds to "determination device", and the test controller 26 which executes processing in step S140 of the electrode testing process routine corresponds to "testing device".

According to the embodiment described in detail above, since a short-circuit test is conducted using two probes 12, each one probe 12 from each of the pairs of probes 12, after an electrical conduction determination that determines the presence of electrical conduction of the pairs of probes 12 contacting the respective terminal electrodes 134 is performed, a short-circuit determination error caused by the fact that the probes 12 are not in contact with the terminal electrodes 134 is prevented, thereby improving the reliability of the test. In addition, because re-conducting of a short-circuit test due to a determination error is prevented, even if an electrical conduction determination is performed prior to a short-circuit test, a test can be efficiently conducted. Therefore, the reliability of a test can be improved, and an efficient test can be conducted.

In addition, the gas sensor 100 has the eight terminal electrodes 134, and it is necessary to conduct a short-circuit test on 28 combinations. Since re-conducting of a short-circuit test due to a determination error can be prevented, the test becomes more efficient. Furthermore, since a short-circuit test is conducted after completion of an electrical conduction determination, the test becomes even more efficient, compared with the case in which an electrical conduction determination is performed during a short-circuit test. In addition, since two (a pair of) probes 12 are connected to each terminal electrode 134, an electrical conduction determination between the probes 12 (checking of contact with the terminal electrode 134) can be easily performed, and the number of probes 12 to be prepared can be limited to a minimum.

It is apparent that the present invention is not limited to the above-described embodiment at all and various embodiments can be made within the technical scope of the present invention.

Although the gas sensor 100 with three or more (eight) terminal electrodes 134 has been described by way of example in the above-described embodiment, the embodiment is not limited to this case, and any apparatus that conducts a test between two electrodes is applicable.

Although it has been described in the above-described embodiment that a short-circuit test is conducted using two probes 12, each one probe 12 from each of the pairs of probes 12 where electrical conduction has been confirmed, it is sufficient to conduct a short-circuit test using at least one probe 12 from each of the pairs of probes 12 where electrical conduction has been confirmed. Alternatively, a short-circuit test may be conducted using both probes 12 from each of the pairs of probes 12 where electrical conduction has been confirmed.

Although it has been described in the above-described embodiment that an electrical conduction determination is performed by causing the pairs of probes 12 to contact the respective terminal electrodes 134, the embodiment is not limited to this case. An electrical conduction determination may be performed by causing at least two (may be two or three, or more) probes 12 to contact each terminal electrode 134. In this case, out of at least two probes 12 contacting each terminal electrode 134, a short-circuit test may be conducted using at least one probe 12 where electrical conduction has been confirmed (may be one probe 12 or may be plural probes 12 where electrical conduction has been confirmed).

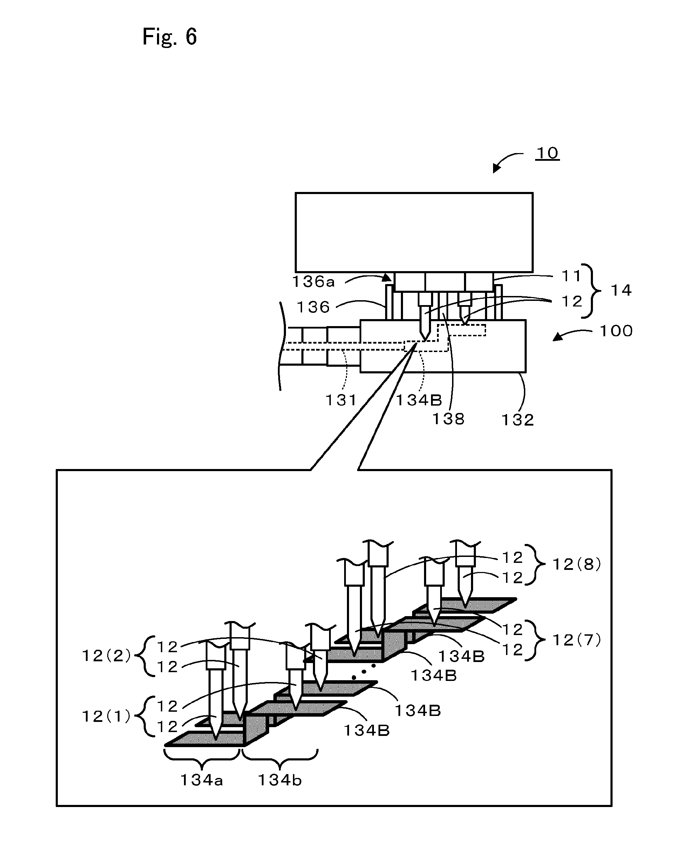

Although the shape of the terminal electrodes 134 of the connector 132 is planar in the above-described embodiment, the embodiment is not limited to this case, and the terminal electrodes 134 may be of any shape. For example, multilevel terminal electrodes 134B each having the first area 134a and the second area 134b that have different heights may be used. In this case, Fig. 6 illustrates how the probes 12 of the electrode testing apparatus 10 and the terminal electrodes 134B contact each other. Since the configuration of the electrode testing apparatus 10 is the same as that in Fig. 1, an illustration thereof is omitted in Fig. 6. As illustrated in Fig. 6, one probe 12 of each of the pairs of probes 12 contacts the first area 134a, which is a lower portion of a corresponding one of the terminal electrodes 134B, and the other probe 12 contacts the second area 134b, which is a higher portion of the terminal electrode 134B. As has been described above, since the probes 12 are capable of extending in the vertical direction, the probes 12 facing the second areas 134b contact the second areas 134b while the probes 12 are shrinking more than the probes 12 facing the first areas 134a. In this manner, each of the terminal electrodes 134B is formed to be multilevel, and one probe 12 is caused to contact each of the low portion (first area 134a) and the high portion (second area 134b). Accordingly, as with the case of the above-described embodiment, after an electrical conduction determination that determines the presence of electrical conduction of the pairs of probes 12 is performed, a short-circuit test can be conducted using two probes 12, each one probe 12 from each of the pairs of probes 12 determined to be electrically conducting. That is, advantageous effects similar to those of the above-described embodiment can be achieved even in a test on the terminal electrodes 134B formed to be multilevel.

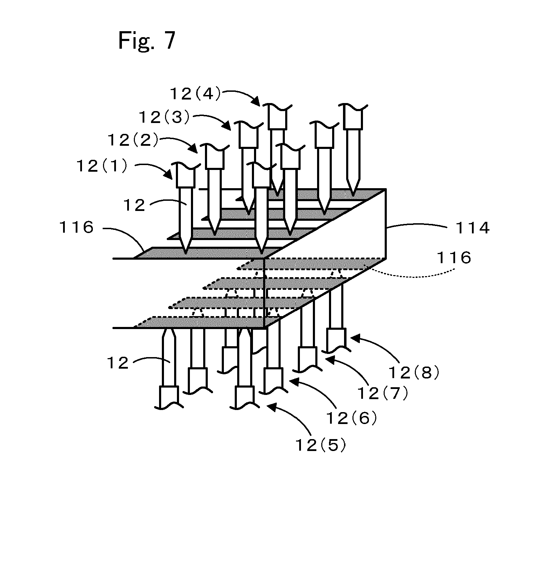

Although the terminal electrodes 134 of the connector 132 of the gas sensor 100 are tested in the above-described embodiment, the embodiment is not limited to this case, and the element electrodes 116 provided on the sensor element 114 of the gas sensor 100 may be tested. In this case, Fig. 7 illustrates how the probes 12 contact the element electrodes 116 of the sensor element 114. As illustrated in Fig. 7, each pair of probes 12 contacts a corresponding one of the eight element electrodes 116, four of which are provided on the front and back sides of the sensor element 114. A test on these element electrodes 116 is conducted, as with the case of the above-described embodiment. After an electrical conduction determination that determines the presence of electrical conduction of the pairs of probes 12 is performed, a short-circuit test can be conducted using two probes 12, each one probe 12 of each of the pairs of probes 12 determined to be electrically conducting. That is, advantageous effects similar to those of the above-described embodiment can be achieved even in a test on the element electrodes 116. In addition, the embodiment is not limited to testing electrodes (the terminal electrodes 134 or the element electrodes 116) of the gas sensor 100 which detects a gas concentration, and the embodiment is applicable to testing electrodes of a sensor that detects another physical amount other than a gas concentration, or testing electrodes of a semiconductor circuit such as a CPU, instead of a sensor. Also in these electrode tests, advantageous effects similar to those of the above-described embodiment can be achieved by conducting a test similar to that of the above-described embodiment.

Although it has been described in the above-described embodiment that a short-circuit test is conducted after completion of an electrical conduction determination of the probes 12, the embodiment is not limited to this case, and electrical conduction of the probes 12 contacting electrodes to be tested may be determined during a short-circuit test. In this case, the electrode testing apparatus 10 is not limited to one including the same number of pairs of probes 12 as the number of electrodes, and the electrode testing apparatus 10 may include fewer pairs of probes 12 than the number of electrodes.

Although it has been described in the above-described embodiment that the value of a resistance between two probes 12 is detected on the basis of a reference voltage, a voltage generated at a reference resistor R, and the resistance value of the reference resistor R, and is output to the test controller 26 by the resistance value detector, the embodiment is not limited to this case, and, for example, the value of a current flowing through a circuit may be detected, and the value of a resistance between two probes 12 may be detected. In addition, the resistance value detector 18 is not limited to one that outputs a resistance value to the test controller 26. The resistance value detector 18 may output values necessary for detection of a resistance value (such as a voltage value and a current value) to the test controller 26, and the test controller 26 may derive a resistance value.

Although a short-circuit test is given as an example of a test of electrical characteristics between electrodes in the above-described embodiment, the embodiment is not limited to this case. A test may be any test that applies a current or a voltage across electrodes and that tests the electrical characteristics, and it is only sufficient that an electrical conduction determination be performed prior to that test.

### INDUSTRIAL APPLICABILITY

The present invention is usable in the industry of manufacturing, for example, a gas sensor that measures a gas concentration of NOx, O₂, or the like.

## Claims

1. An electrode testing method that tests electrical characteristics between two electrodes, comprising:
a determination step of determining, at each of the electrodes, in a state in which at least two probes contact each of the electrodes, electrical conduction between the at least two probes contacting the same electrode; and
a testing step of testing electrical characteristics between the electrodes using at least one probe at each of the electrodes, among probes determined to be electrically conducting in the determination step.

2. The electrode testing method according to Claim 1,
wherein, in the determination step, in a state in which the two probes contact each of the electrodes, electrical conduction between the two probes contacting the same electrode is determined at each of the electrodes, and
wherein, in the testing step, electrical characteristics between the electrodes are tested using each one probe at each of the electrodes, among probes determined to be electrically conducting in the determination step.

3. The electrode testing method according to Claim 1 or 2,
wherein the electrodes include a combination of two electrodes, among three or more electrodes.

4. The electrode testing method according to Claim 3,
wherein, in the determination step, in a state in which the at least two probes contact each of the electrodes, electrical conduction between the at least two probes contacting the same electrode is determined at each of the electrodes, and
wherein the testing step is performed after it is determined in the determination step that at least one probe is electrically conducting at each of the electrodes.

5. The electrode testing method according to any one of Claims 1 to 4,
wherein each of the electrodes is provided at a gas sensor that detects a gas concentration of a gas to be measured.

6. An electrode testing apparatus that tests electrical characteristics between two electrodes, comprising:
at least two probes provided for each of the electrodes;
determination device that determines, at each of the electrodes, in a state in which the probes contact each of the electrodes, electrical conduction between the at least two probes contacting the same electrode; and
testing device that tests electrical characteristics between the electrodes using at least one probe at each of the electrodes, among probes determined by the determination device to be electrically conducting.
